# FASCICULE DE BREVET EUROPEEN

(11) **EP 3 712 744 B1**
(45) Date de publication et mention de la délivrance du brevet: **28.12.2022**
(21) Numéro de dépôt: 20163449.0
(22) Date de dépôt: 16.03.2020
(51) Int. Cl.: G06F 1/20, H01L 23/367, H01L 23/473, H05K 7/20, H01L 23/40

(54) **DISSIPATEUR THERMIQUE POUR PLUSIEURS BARRETTES MEMOIRE**
KÜHLKÖRPER FÜR MEHRERE SPEICHER-ARRAYS
HEAT SINK FOR A PLURALITY OF MEMORY MODULES

(30) Priorité: 19.03.2019 FR 1902830
(43) Date de publication de la demande: 23.09.2020
(73) Titulaire: Bull SAS, 78340 Les Clayes-sous-Bois (FR)
(72) Inventeur: DALLASERRA, Luc, 75009 Paris (FR); RAETH, Marc, 78910 Tacoignieres (FR)
(74) Mandataire: Cabinet Camus Lebkiri

(56) Documents cités:
- WO-A1-2016/122674
- US-A1- 2006 250 772
- US-A1- 2008 084 668

## Description

### DOMAINE TECHNIQUE DE L'INVENTION

Le domaine technique de l'invention est celui des systèmes de refroidissement de barrettes mémoire.

La présente invention concerne un système de refroidissement de barrette mémoire et en particulier de barrettes mémoire pour des lames de calcul montables dans le bâti d'une armoire informatique.

### ARRIERE-PLAN TECHNOLOGIQUE DE L'INVENTION

Les lames de calcul pour armoires informatiques peuvent comprendre par exemple des processeurs, des cartes graphiques, de la mémoire vive telle que des barrettes mémoire, du stockage de masse tel que des disques durs. Ces lames de calcul sont par exemple utilisées pour réaliser du calcul haute performance, ses éléments dégagent donc de la chaleur en fonctionnement et doivent être refroidis pour assurer leur bon fonctionnement et leur durabilité.

Etant montées sur bâti, la circulation d'air n'est pas suffisante au sein des armoires informatiques pour refroidir efficacement les lames de calcul en utilisant des système de refroidissement à air.

C'est pourquoi des systèmes de refroidissement fluidiques ont été développés. Ces systèmes de refroidissement comprennent par exemple des tuyaux, le plus souvent en cuivre, dans lesquels circule un fluide. Ces tuyaux peuvent être connectés directement aux composants à refroidir, par exemple en formant une boucle autour des composants. Le fluide peut aussi circuler entre deux plaques, par exemple de métal, au moins une des deux plaques étant directement connectée à un composant à refroidir. Il est aussi possible de braser des canaux à l'intérieur d'une plaque de métal, par exemple du cuivre, pour y faire passer le fluide. Le fluide peut ainsi circuler dans une plaque de métal connectée à un composant, par exemple le long d'une barrette mémoire.

Ces systèmes de refroidissement fluidiques sont encombrants car ils nécessitent un espace autour des composants pour les plaques en métal accueillant le fluide.

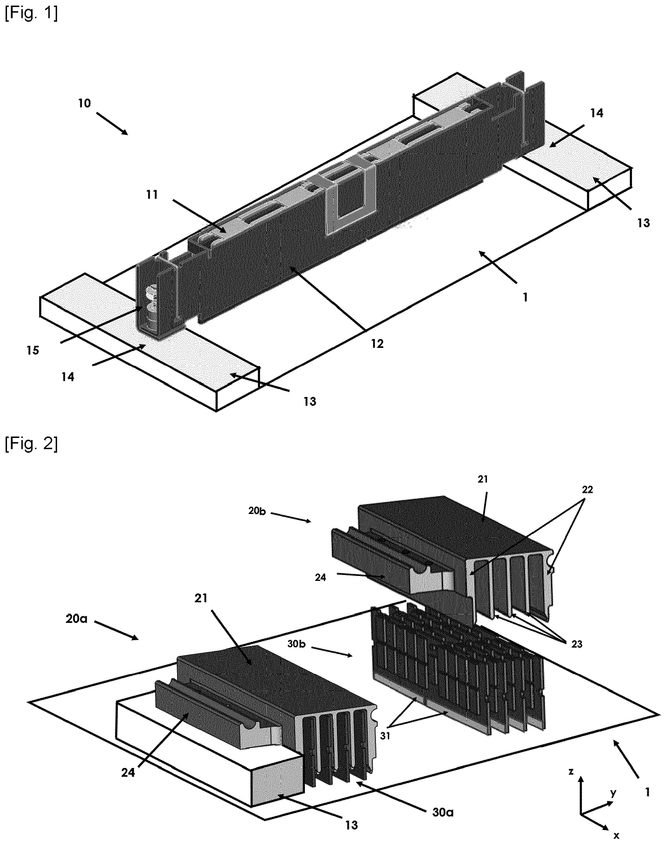

D'autres systèmes de refroidissement hybrides existent, possédant les avantages du refroidissement fluidique et ceux du refroidissement par contact sec. C'est le cas par exemple du brevet FR2966318 intitulé « Carte électronique pourvue d'un système de refroidissement liquide » qui propose un système de refroidissement comprenant un module de refroidissement dans lequel circule un liquide de refroidissement, et un dissipateur amovible conducteur, se plaçant en contact avec les surfaces d'un composant électronique au travers d'un matériau thermique pour récupérer les calories produites par le composant, le dissipateur étant en contact sec avec le module de refroidissement de manière amovible, par exemple par des vis. Ce système connu de l'état de la technique est présenté Figure 1. Ce système permet d'avoir un encombrement réduit autour du composant, car aucun fluide ne circule autour du composant. D'autres systèmes de refroidissement sont connus par exemple des documents WO 2016/122674 A1 et US 2006/250772 A1

[Fig. 1] représente un système de refroidissement selon l'état de la technique.

Ainsi, dans le système de refroidissement 10 représenté Figure 1, les calories produites par le composant électronique 11 sont récupérées par le dissipateur 12 via un coussinet thermique puis transmises au module de refroidissement 13 via les points de contact sec 14. Le dissipateur 12 et le module de refroidissement 13 sont maintenus ensemble par des vis 15 par contact sec. Cela rend le dissipateur 12 amovible, permettant l'accès au composant 11. Le seul point de contact du dissipateur 12 avec le module de refroidissement 13 est donc le point de contact sec 14.

Le module de refroidissement 13 est aussi appelé « plaque froide » et peut être par exemple être en métal, par exemple en aluminium. Cette plaque froide peut par exemple parcourir l'ensemble de la lame de calcul et au moins une partie des composants de la lame de calcul peuvent y être connectés. Le composant électronique 11 peut par exemple être une barrette mémoire.

On entend par « barrette mémoire » un composant électronique à mémoire vive permettant le stockage et l'effacement d'informations traitées par un dispositif informatiques. On entend par « mémoire vive » une mémoire dont le temps d'accès est court et étant volatiles, c'est-à-dire entraînant une perte de toutes les données en mémoire lorsqu'elle n'est plus alimentée.

Avec les avancées technologiques, il existe un besoin d'intégrer plus de mémoire vive sur une lame de calcul de même dimension contrainte. Une solution peut être d'augmenter la capacité mémoire des barrettes mémoire refroidies par le système 10 de l'état de la technique. Mais le coût d'une barrette mémoire par rapport à sa capacité n'étant pas linéaire, l'augmentation de la capacité d'une barrette mémoire entraîne une augmentation de son coût beaucoup plus importante proportionnellement. Le coût d'une lame de calcul augmente donc de manière très importante avec cette solution. Une seconde solution est d'augmenter le nombre de barrettes mémoire sur une lame de calcul, afin d'avoir plus de mémoire vive par processeur tout en limitant le coût en ayant des barrettes mémoire de capacité moins importante donc moins coûteuses.

Cependant, les dimensions d'une lame de calcul montable dans le bâti d'une armoire informatique sont contraintes, notamment par le standard de 19 pouces. En effet, la largeur totale du bac à cartes du bâti des armoires de calcul de l'état de la technique est de 482,6 mm, c'est-à-dire de 19 pouces, équerres de fixation comprises. Cette largeur est à l'origine du système de montage 19 pouces. Ainsi, la largeur des éléments accueillis par le bâti des armoires informatiques de l'état de la technique respecte ce standard de 19 pouces, et la lame de calcul a donc des dimensions contraintes.

De plus, le dissipateur 12 de l'art antérieur oblige à avoir un pas entre deux composants 11 placés côté-à-côte. Ce pas est dû d'une part à l'encombrement du coussinet thermique séparant le composant 11 et le dissipateur 12. D'autre part, ce pas est nécessaire pour pouvoir venir envelopper le composant 11 avec le dissipateur 12 lors du montage du composant 11 et du dissipateur 12, ou pour pouvoir enlever le dissipateur 12 du composant 11 afin d'avoir accès au composant 11. Ce pas est par exemple de l'ordre de 11 millimètres dans le cas où les composants 11 sont des barrettes mémoire.

Cependant, les connecteurs actuels de barrettes mémoire, permettant de connecter une barrette mémoire sur une carte électronique de lame de calcul, permettent un pas minimal entre deux connecteurs de 8 millimètres. Ce pas est aussi nécessaire notamment pour respecter les règles de routage.

Il n'est alors pas possible de réduire le pas entre deux barrettes mémoire pour augmenter le nombre de barrettes mémoire sur une lame de calcul de dimension contrainte tout en utilisant le système de refroidissement 10 de l'état de la technique.

De plus, le système de refroidissement 10 de l'état de la technique est coûteux à la fabrication car il nécessite, pour chaque composant 11, au moins deux vis et plusieurs plaques de cuivre.

Il existe donc un besoin d'un système de refroidissement pour barrettes mémoire permettant de respecter le pas minimal entre deux barrettes mémoire tout en utilisant un refroidissement fluidique et en étant moins coûteux que les systèmes de refroidissement de l'état de la technique.

### RESUME DE L'INVENTION

L'invention offre une solution aux problèmes évoqués précédemment, en permettant un refroidissement efficace de plusieurs barrettes mémoires séparées d'un pas inférieur au pas de l'art antérieur entre deux barrettes mémoires, et donc d'avoir plus de barrettes mémoire sur une lame de calcul de dimensions contraintes tout en permettant une fabrication moins coûteuse.

Un aspect de l'invention concerne ainsi un dissipateur thermique pour une pluralité de barrettes mémoire connectables à une carte électronique, ladite carte électronique comprenant au moins un système de refroidissement fluidique et au moins un premier connecteur pour chaque barrette mémoire de la pluralité de barrettes mémoire, chaque barrette mémoire comprenant au moins un deuxième connecteur configuré pour être connecté au au moins un premier connecteur de la carte électronique et deux surfaces d'échange thermique, caractérisé en ce que :
- le dissipateur thermique comprend au moins une enveloppe, ladite enveloppe comprenant:
   - une surface supérieure configurée pour recouvrir au moins partiellement la partie supérieure de chaque barrette mémoire de la pluralité de barrettes mémoire,
   - au moins deux pattes extérieures, chaque patte extérieure étant configurée pour être en contact thermique avec au moins une surface d'échange thermique parmi les deux surfaces d'échange thermique d'au moins une barrette mémoire de la pluralité de barrettes mémoire,

   - au moins une surface de contact, configurée pour être en contact thermique avec ledit système de refroidissement fluidique de ladite carte électronique lorsque chaque barrette mémoire de la pluralité de barrettes mémoire est connectée à ladite carte électronique,
   - au moins une patte intérieure, configurée pour être intercalée entre deux barrettes mémoire de la pluralité de barrettes mémoire afin de réaliser un contact thermique avec au moins une surface d'échange thermique parmi les deux surfaces d'échange thermique de chacune des deux barrettes mémoire, présentant une forme biseauté ou arrondie au niveau de sa surface inférieure,
- ladite enveloppe est configurée pour être placée de manière amovible contre les deux surfaces d'échange de chaque barrette mémoire de la pluralité de barrettes mémoire,
- ladite enveloppe est configurée pour être fixée mécaniquement de manière amovible à ladite carte électronique lorsque chaque barrette mémoire de la pluralité de barrettes mémoire est connectée à ladite carte électronique.

L'invention permet avantageusement de réduire le pas entre deux barrettes mémoire, en ayant avantageusement une seule patte intérieure du dissipateur intercalées entre deux barrettes mémoire. Cela permet de placer plus de barrettes mémoire sur une carte électronique de même dimension qu'une carte électronique de l'état de la technique.

Grâce à l'invention, il est possible de refroidir plusieurs barrettes mémoire avec un seul dissipateur, permettant avantageusement un coût de fabrication moindre.

La surface supérieure configurée pour recouvrir chaque barrette mémoire permet avantageusement d'avoir le chemin thermique le plus court possible entre la source froide et chacune des barrettes mémoire sans avoir la source froide entre les barrettes mémoire.

Avantageusement, l'enveloppe du dissipateur thermique est amovible, permettant d'avoir un accès simple aux barrettes mémoire, par exemple pour remplacer une barrette mémoire lorsque celle-ci s'avère défaillante ou lorsque l'on souhaite en augmenter la capacité.

L'invention permet avantageusement, en ayant une patte intérieure en contact thermique avec au moins une surface de chacune des deux barrettes mémoire entre lesquelles elle est intercalée, de capter une grande partie de la chaleur émise par les deux barrettes.

Comprenant une surface de contact en contact thermique avec le système de refroidissement fluidique de la carte électronique lorsque les barrettes mémoires avec lesquelles il est en contact sont connectées à la carte électronique, c'est-à-dire lorsqu'elles sont en fonctionnement et donc lorsqu'elles chauffent, le dissipateur thermique permet de rediriger la chaleur de toutes les barrettes mémoires avec lesquelles il est en contact vers le système de refroidissement fluidique.

Ainsi, en captant et en redirigeant la chaleur émise par les barrettes mémoire avec lesquelles il est en contact, le dissipateur thermique permet de garantir la durabilité et le bon fonctionnement de plusieurs barrettes mémoire à lui seul.

Le contact thermique de l'enveloppe du dissipateur avec le système de refroidissement fluidique permet avantageusement de ne pas avoir de fluide à faire circuler autour des barrettes mémoire. Ainsi, les problèmes d'encombrement liés par exemple aux conduites d'entrée et de sortie d'un liquide des solutions de l'état de l'art sont évités. Cela permet d'avoir un pas réduit entre les barrettes mémoire.

Outre les caractéristiques qui viennent d'être évoquées dans le paragraphe précédent, le dissipateur thermique selon un aspect de l'invention peut présenter une ou plusieurs caractéristiques complémentaires parmi les suivantes, considérées individuellement ou selon toutes les combinaisons techniquement possibles :
- Le dissipateur thermique comprend en outre une pluralité d'interfaces thermiques, chaque interface thermique étant intercalée soit entre une surface d'échange d'une barrette mémoire de la pluralité de barrettes mémoire et une patte extérieure de l'enveloppe, soit entre une surface d'échange d'une barrette mémoire de la pluralité de barrettes mémoire et une patte intérieure de l'enveloppe.
- La au moins une surface supérieure, les au moins deux pattes extérieures et la au moins une patte intérieure du dissipateur thermique sont agencées de façon à former, pour chaque barrette mémoire de la pluralité de barrettes mémoire, un espace adapté à recevoir la barrette mémoire.
- Le dissipateur thermique comprend deux surfaces de contact, chaque surface de contact étant en contact thermique avec le système de refroidissement fluidique.
- Le dissipateur thermique comprend deux surfaces supérieures.
- Le dissipateur thermique comprend en outre un caloduc configuré pour être en contact thermique avec la surface de contact et avec la patte extérieure de l'enveloppe du dissipateur thermique la plus éloignée de la surface de contact.

Les interfaces thermiques permettent de ne pas endommager les barrettes mémoire au moment de l'insertion de l'enveloppe et de réaliser un contact thermique plus efficace.

En comprenant deux surfaces de contact chacune en contact thermique avec le système de refroidissement fluidique, le dissipateur thermique selon l'invention permet un meilleur refroidissement de la pluralité de barrettes mémoire.

Un avantage de comprendre un caloduc est que le dissipateur thermique selon l'invention peut mieux refroidir les barrettes mémoire les plus éloignées du système de refroidissement fluidique.

Un autre aspect de l'invention concerne une carte électronique comprenant au moins un système de refroidissement fluidique, une pluralité de barrettes mémoire, au moins un premier connecteur électrique pour chaque barrette mémoire, chaque barrette mémoire comprenant au moins un deuxième connecteur configuré pour être connecté à au moins un premier connecteur de la carte électronique et le dissipateur thermique selon l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique d'un système de refroidissement selon l'état de la technique.
- La figure 2 montre une représentation schématique de deux dissipateurs thermiques pour barrette mémoire selon un premier mode de réalisation de l'invention.
- La figure 3 montre une représentation schématique d'un dissipateur thermique selon le premier mode de réalisation de l'invention dans une vue selon un plan perpendiculaire au plan de la carte électronique 1.
- La figure 4 montre une représentation schématique d'un dissipateur thermique selon un deuxième mode de réalisation de l'invention dans une vue selon un plan perpendiculaire au plan de la carte électronique 1.
- La figure 5 montre une représentation schématique d'un dissipateur thermique selon un deuxième mode de réalisation de l'invention dans une vue de dessus une vue de dessus dans le plan de la carte électronique 1.
- La figure 6 montre une représentation schématique d'un dissipateur thermique selon un troisième mode de réalisation de l'invention dans une vue selon un plan perpendiculaire au plan de la carte électronique 1.
- La figure 7 montre une représentation schématique d'un dissipateur thermique selon une variante au troisième mode de réalisation de l'invention dans une vue selon un plan perpendiculaire au plan de la carte électronique 1.

### DESCRIPTION DETAILLEE D'AU MOINS UN MODE DE REALISATION DE L'INVENTION

Les figures sont présentées à titre indicatif et nullement limitatif de l'invention. Sauf précision contraire, un même élément apparaissant sur des figures différentes présente une référence unique.

[Fig. 2] montre une représentation schématique de deux dissipateurs thermiques pour barrette mémoire selon un premier mode de réalisation de l'invention.

La figure 2 représente une carte électronique 1 comprenant un système de refroidissement fluidique 13. Ce système de refroidissement fluidique 13 est connu de l'homme de l'art. Il comprend en outre une entrée et une sortie de fluide. Ce système de refroidissement fluidique 13 peut être par exemple une plaque froide, s'étendant sur une grande partie de la surface de la carte électronique 13 afin que chacun des dissipateurs thermiques selon l'invention soit en contact thermique avec la même plaque froide et donc au même système de refroidissement fluidique 13.

Lorsque l'on mentionne que deux éléments sont « en contact thermique », on entend qu'au moins une surface d'un élément capte la chaleur émise par l'autre surface , soit en étant en contact direct, soit à travers une interface thermique, par exemple formée d'une pâte thermique ou de tout matériau thermique.

Sur la figure 2 sont en outre représentées deux enveloppes 20a et 20b, chacune formant un dissipateur thermique selon l'invention, et une pluralité de barrettes mémoire 30a et 30b. La carte électronique 1 comprend en outre au moins un premier connecteur (non représenté) par barrette mémoire de la pluralité de barrettes mémoire 30, configuré pour être connecté à au moins un deuxième connecteur d'une barrette mémoire.

De manière non limitative, chaque enveloppe 20a et 20b comprend une surface supérieure 21, deux pattes extérieures 22, trois pattes intérieures 23 et une surface de contact 24.

La pluralité de barrettes mémoire 30a ou 30b peut par exemple comprendre des barrettes mémoire au format DIMM (selon la dénomination anglo-saxonne « Dual Inline Memory Module » traduit littéralement en français par « Module Mémoire à Double Rangée »). Une barrette mémoire au format DIMM comprend deux rangées de contacts, une de chaque côté de la barrette mémoire, les contacts de chaque face étant électriquement séparés des contacts de l'autre face. Selon une variante, la pluralité de barrettes mémoires 30a ou 30b peut par exemple comprendre des barrettes mémoire au format SIMM (selon la dénomination anglo-saxonne « Single Inline Memory Module » traduit littéralement en français par « Module Mémoire à Simple Rangée »). Une barrette mémoire au format SIMM comprend deux rangées de contacts, une de chaque côté de la barrette mémoire, les contacts de chaque face étant les mêmes que sur l'autre face. Il apparaît que l'homme du métier peut en outre utiliser tout autre format de barrettes mémoire connu de l'état de l'art pour mettre en œuvre l'invention.

De manière non limitative, chaque barrette mémoire de la pluralité de barrettes mémoire 30a ou 30b comprend une rangée de contacts électriques sur une face et une rangée de contacts électriques sur l'autre face (non représentée). Ainsi, une barrette mémoire comprend par exemple un deuxième connecteur 31 comprenant 2 rangées de contacts électriques. Il est possible qu'une ou plusieurs barrettes mémoire de la pluralité de barrettes mémoire 30 comprenne en outre une pluralité de deuxièmes connecteurs, selon les formats de barrettes mémoire connus de l'état de l'art.

Le deuxième connecteur 31 est configuré pour être connecté à un premier connecteur de la carte électronique 1. Lorsqu'une barrette mémoire comprend une pluralité de deuxièmes connecteurs 31, la carte électronique 1 comprend une pluralité de premiers connecteurs configurés pour être connectés à la pluralité de deuxième connecteurs.

Par la suite, lorsque l'on mentionnera qu'une barrette mémoire est « connectée » à la carte électronique 1, on entendra que le premier connecteur de la carte électronique 1 est connecté au deuxième connecteur de la barrette mémoire.

Chaque barrette mémoire comprend deux surfaces d'échange thermique. On entend par « surface d'échange thermique » d'une barrette mémoire ses deux surfaces latérales. Une surface d'échange thermique d'une barrette mémoire de la pluralité de barrettes mémoire 30a ou 30b est une surface de la barrette mémoire située dans le plan formé par les axes longitudinal x et vertical z lorsque la barrette mémoire est orientée selon l'axe x comme représenté à la figure 2.

Les enveloppes 20a et 20b, formant chacune un dissipateur thermique selon le premier mode de réalisation de l'invention, permettent de récupérer la chaleur émise par la pluralité de barrettes mémoire respectivement 30a et 30b lorsqu'elles sont en fonctionnement, c'est-à-dire lorsqu'elles sont connectées à la carte électronique 1. Cette chaleur est alors redirigée vers le système de refroidissement fluidique 13.

Chaque enveloppe 20a et 20b comprend une surface supérieure 21, configurée pour recouvrir au moins partiellement la partie supérieure d'au moins une barrette mémoire de la pluralité de barrettes mémoire 30a ou 30b. On entend par « recouvrir » la partie supérieure d'une barrette mémoire le fait que la surface supérieure 21 soit placée au-dessus de la partie supérieure d'une barrette mémoire. C'est-à-dire que lorsque l'on a une vue de dessus de l'enveloppe 20a ou 20b et de la pluralité de barrettes mémoire 30a ou 30b, la surface supérieure 21 est visible et cache au moins en partie la partie supérieure des barrettes mémoire, lorsque la surface supérieure 21 est réalisée dans un matériau opaque. On entend par « partie supérieure » d'une barrette mémoire la tranche supérieure d'une barrette mémoire lorsque celle-ci est en position debout, c'est-à-dire quand son connecteur 31 est vers le bas, comme représenté à la figure 2. Cette surface supérieure, en contact thermique avec les pattes extérieures 22, les pattes intérieures 23 et la surface de contact 24, permet de créer un chemin thermique court entre les barrettes mémoire 30 et le systèmes de refroidissement fluidique 13. La surface supérieure 21 permet aussi une rigidité de l'ensemble de l'enveloppe 20 et permet de maintenir ensemble les pattes extérieures 22 et les pattes intérieures 23. La surface supérieure 21 peut aussi permettre de maintenir un écart constant entre une première patte extérieure 22 et une patte intérieure 23, entre deux pattes intérieures 23, et entre une patte intérieure 23 et une deuxième patte extérieure 22. Cet écart constant permet d'envelopper chaque barrette mémoire de la pluralité de mémoire 30a ou 30b avec l'enveloppe 20a ou 20b. Il est donc nécessaire que cet écart soit de distance plus grande que l'épaisseur d'une barrette mémoire.

Les enveloppes 20a et 20b comprennent chacune une pluralité de pattes extérieures 22, par exemple deux pattes extérieures 22, configurées pour être en contact thermique avec au moins une surface d'échange thermique d'au moins une barrette mémoire de la pluralité de barrettes mémoire 30a ou 30b. Par exemple, chaque patte extérieure 22 de l'enveloppe 20a de la figure 2 est en contact thermique avec une surface d'échange thermique d'une barrette mémoire de la pluralité de barrettes mémoire 30a. Ainsi, selon l'axe y représenté figure 2, la première patte extérieure 22, la plus à gauche selon l'axe y, est en contact thermique avec la première surface d'échange de la première barrette mémoire, la plus à gauche de la pluralité de barrettes mémoire 30a. Toujours selon l'axe y représenté figure 2, la deuxième patte extérieure 22, la plus à droite de l'enveloppe 20a selon l'axe y, est en contact thermique avec la deuxième surface d'échange de la dernière barrette mémoire, la plus à droite de la pluralité de barrettes mémoire 30a.

La première surface d'échange thermique d'une barrette mémoire est par exemple sa surface d'échange de gauche selon l'axe y, et la deuxième surface d'échange thermique est par exemple la surface opposée à sa première surface déchange, c'est-à-dire sa surface de droite selon l'axe y de la figure 2.

Les enveloppes 20a et 20b comprennent chacune au moins une patte intérieure 23, par exemple trois pattes intérieures 23, chaque patte intérieure étant configurée pour être intercalée entre deux barrettes mémoires de la pluralité de barrettes mémoires 30 a ou 30b afin de réaliser un contact thermique avec au moins une surface d'échange de chacune des deux barrettes mémoire.

Par exemple, comme représenté Figure 2, la patte intérieure 23 de l'enveloppe 20b la plus à gauche selon l'axe y est configurée pour être intercalée entre deux barrettes mémoire, par exemple entre les deux barrettes mémoire le plus à gauche de la pluralité de barrettes mémoire 30b selon l'axe y. Lorsque les barrettes mémoire de la pluralité de barrettes mémoire 30a sont connectées à la carte électronique 1, et que l'enveloppe 20a enveloppe les barrettes mémoires, les pattes intérieures 23 sont intercalées entre deux barrettes mémoire. Ainsi, la patte 23 de l'enveloppe 20a la plus à gauche selon l'axe y est intercalée entre les deux barrettes mémoire les plus à gauche selon l'axe y de la pluralité de barrettes mémoire 30a. Cela permet de réaliser :
- un premier contact thermique entre la deuxième surface d'échange thermique de la première barrette mémoire selon l'axe y et la première patte intérieure 23 ;
- un second contact thermique entre la première surface d'échange thermique de la seconde barrette mémoire et la première patte intérieure.

Pour cela, la patte intérieure 23 peut comprendre deux surfaces d'échange thermique comme représenté à la Figure 2. De la même manière que pour une barrette mémoire, une patte intérieure peut comprendre une première surface d'échange thermique et une deuxième surface d'échange thermique, chaque surface d'échange thermique de la patte intérieure 23 se situant dans le même plan que les surfaces d'échange thermique d'une barrette mémoire. Les pattes intérieures 23 permettant ainsi de récupérer une partie de la chaleur produite par les deux barrettes mémoire entre lesquelles elle est intercalée. Les pattes intérieures 23 sont en contact thermique avec la surface supérieure 21, par exemple en étant solidaires de la surface supérieure 21. Ce contact thermique permet de rediriger la chaleur récupérée des barrettes mémoire vers la surface de contact 24 via la surface supérieure 21.

Les pattes intérieures 23 permettent de plus d'avoir un écart entre deux barrettes mémoire inférieur à un écart de l'art antérieur tout en ayant un refroidissement efficace. En effet, une seule patte est nécessaire entre deux barrettes mémoire. Le seul facteur de l'enveloppe 20a ou 20b impactant l'espacement entre deux barrettes mémoire sur la carte électronique 1 est ainsi l'épaisseur d'une patte intérieure 23. Grâce à l'invention, il est notamment possible de refroidir efficacement une pluralité de barrettes mémoire avec un seul dispositif, le dissipateur thermique. En minimisant l'encombrement du dispositif et en utilisant des pattes intérieures 23, il est aussi possible de mettre plus de barrettes mémoire sur une carte électronique 1 de même dimension que dans l'art antérieur par exemple.

Les enveloppes 20a et 20b comprennent chacune une surface de contact 24. La surface de contact 24 peut par exemple être un bloc rectangulaire comme représenté à la Figure 2. La surface de contact 24 est configurée pour être en contact thermique avec le système de refroidissement fluidique 13, afin de rediriger la chaleur des barrettes mémoire captée par les pattes extérieures 22 et par les pattes intérieures 23 vers le système de refroidissement fluidique 13. Dans un mode de réalisation préférentiel, la surface de contact 24 est configurée pour être en contact thermique avec le système de refroidissement fluidique 13 lorsque les barrettes mémoires sont connectées à la carte électronique 1. La surface de contact 24 peut être en contact direct avec le système de refroidissement 13. Ce contact thermique peut être un contact de la surface de contact 24 avec un waterblock (selon la dénomination anglo-saxonne, traduit littéralement par « bloc d'eau »), utilisé couramment pour refroidir les processeurs d'une lame de calcul par exemple. Ce waterblock étant compris dans le système de refroidissement fluidique 13, la surface de contact 24 est alors en contact thermique avec le système de refroidissement fluidique 13. Dans le cas de l'utilisation de waterblocks comme source froide pour l'invention, il est alors nécessaire d'augmenter le débit de fluide à l'intérieur du waterblock, le waterblock n'ayant plus seulement à capter une majorité des 280 Watts produits par le processeur, mais devant aussi capter une majorité des 80 Watts de la pluralité de barrettes mémoire 30a ou 30b.

La surface de contact 24 peut être par exemple en contact thermique avec un patte extérieure 22, comme représenté figure 2, par exemple en étant solidaire de la patte extérieure 22. Dans une variante, la surface de contact 24 peut être en contact thermique avec la surface supérieure 21 (non représenté).

Les enveloppes 20a et 20b peuvent être en métal, par exemple en cuivre ou en aluminium. Les enveloppes 20a et 20b peuvent aussi être faites d'un alliage, ou de n'importe quel matériau conducteur thermique.

Dans un mode de réalisation préférentiel pour minimiser le coût de fabrication, chaque enveloppe 20a et 20b peut être par exemple en un seul bloc, par exemple en aluminium, duquel de la matière a été extrudée pour réaliser la forme de peigne de l'enveloppe et les surfaces de contact 24, supérieure 21 et les pattes extérieures 22 et intérieures 23. De cette façon, toutes les parties de l'enveloppe sont solidaires afin d'avoir une enveloppe rigide, et une bonne conduction de la chaleur.

Dans un autre mode de réalisation, les enveloppes 20a et 20b ne sont pas en un seul bloc mais en plusieurs parties, par exemple plusieurs parties en forme de « U » brasées ensemble pour créer un ensemble comprenant les pattes intérieures 23, les pattes extérieures 22 et la surface supérieure 21, et un bloc brasé avec l'ensemble pour que l'enveloppe 20a ou 20b ainsi formée comprenne en outre la surface de contact 24.

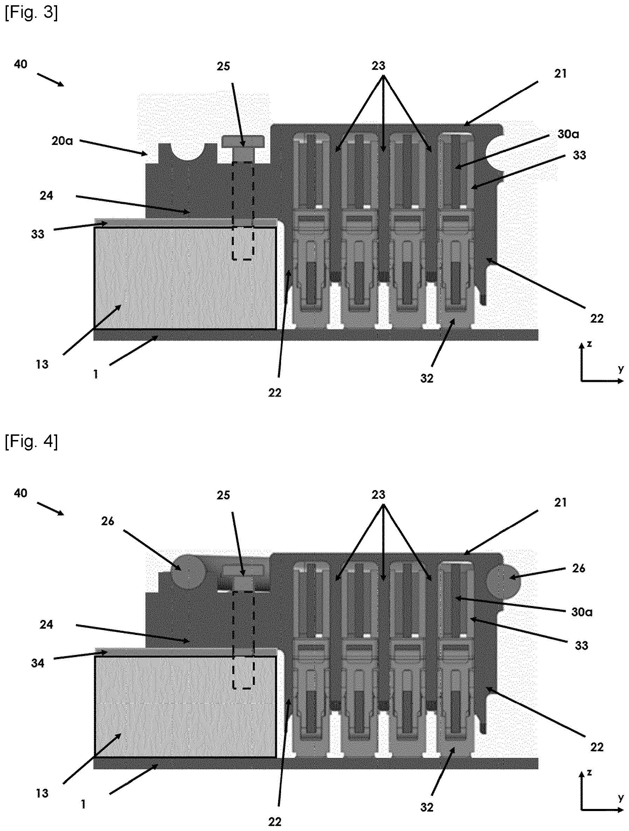

[Fig. 3] représente une vue selon un plan perpendiculaire au plan de la carte électronique 1 d'un dissipateur thermique selon le premier mode de réalisation de l'invention.

Le plan de vue de la figure 3 est un plan selon les axes horizontal y et vertical z. Comme représenté à la figure 3, le dissipateur thermique 40 selon un premier mode de réalisation peut comprendre une enveloppe 20a et un système de fixation amovible 25.

Le système de fixation amovible 25 peut être par exemple une vis, telle qu'une vis imperdable, ou tout autre système permettant de fixer mécaniquement l'enveloppe 20a de manière amovible à la carte électronique 1 lorsque les barrettes mémoire 30a sont connectées à la carte électronique 1. On entend par « fixer de manière amovible » le fait de pouvoir ancrer l'enveloppe 20a de manière que cet ancrage soit réversible, c'est-à-dire que l'enveloppe puisse ne plus être ancrée à la carte électronique 1.

Ce système de fixation amovible 25 de l'enveloppe 20a peut par exemple être une pluralité de vis comprenant un filetage 25, comme représenté à la figure 3. Une pluralité de trous taraudés peut par exemple traverser la surface de contact 24, afin de visser une vis à travers la surface de contact 24.

Un trou, taraudé ou non, peut être réalisé directement dans la carte électronique 1 pour y visser la vis dans le cas où le trou est taraudé, ou pour y faire passer la vis et fixer l'enveloppe par exemple à l'aide d'un écrou.

Dans un mode de réalisation préférentiel, un trou taraudé est présent au niveau du système de refroidissement fluidique 13 comme représenté à la figure 3, pour accueillir une vis comprenant un filetage, permettant ainsi de fixer de manière amovible l'enveloppe 20a au système de refroidissement fluidique 13. Le système de refroidissement fluidique 13 étant compris dans la carte électronique 1, l'enveloppe 20a est ainsi fixée mécaniquement à la carte électronique 1. Cela permet en outre de maintenir de façon certaine la surface de contact 24 en contact thermique avec le système de refroidissement fluidique 13.

La carte électronique 1 comprend une pluralité de premiers connecteurs 32, pour la connexion avec une pluralité de deuxièmes connecteurs 31 compris dans les barrettes mémoires 30a et/ou 30b.

Chaque surface d'échange de chaque barrette mémoire 30a est en contact thermique avec l'enveloppe 20a, soit avec deux pattes intérieures 23, soit avec une patte extérieure 22 et une patte intérieure 23. Ce contact thermique peut être soit un contact direct entre la barrette mémoire et l'enveloppe 20a dans une mode de réalisation non préférentiel.

Dans un mode de réalisation préférentiel, une interface thermique 33 est intercalée entre chaque surface d'échange thermique des barrettes mémoire 30a et l'enveloppe 20a. C'est-à-dire qu'une interface thermique 33 est présente à chaque contact thermique, par exemple entre une surface d'échange thermique d'une barrette mémoire 30a et une patte intérieure 23, par exemple entre une surface d'échange thermique d'une barrette mémoire 30a et une patte extérieure 22.

Cette interface thermique 33 est composée d'un matériau thermique, tel qu'une pâte thermique molle. Par exemple, cette pâte thermique molle peut comprendre du silicone. Un avantage de l'utilisation d'une pâte thermique molle est que celle-ci est déformable. Ainsi, il est possible d'avoir un contact thermique optimal tout en réduisant le risque d'endommager les composants de la barrette mémoire 30a et/ou l'enveloppe 20a. L'interface thermique 33 peut en outre être usinée afin d'être collante d'un côté et lisse d'un autre côté. Cela permet à l'interface thermique 33 d'adhérer à la barrette mémoire 30a et de pouvoir venir envelopper aisément les barrettes mémoires 30a avec le dissipateur thermique 40 comprenant l'enveloppe 20a sans endommager l'interface thermique 33 ni les barrettes mémoires 30a.

Les interfaces thermiques 33 ont des formes et des tailles standards adaptées à être utilisées pour différents types de barrettes mémoire. Par exemple, les interfaces thermiques 33 ont une forme générale sensiblement rectangulaire, avec une épaisseur variant par exemple d'environ 0.5 millimètres à environ 5 millimètres, et le taux de compression admissible pour ces interfaces thermiques est de l'ordre d'environ 1 pourcent à environ 55 pourcents une fois intercalées entre l'enveloppe 20a et les barrettes mémoires 30a au niveau des zones de contact thermique.

Les pattes intérieures 23 et les pattes extérieures 22 ont une forme adaptée pour ne pas endommager les interfaces thermiques 33 lors de l'insertion de l'enveloppe 20a entre et autour des barrettes mémoire 30a. Les pattes intérieures 23 devant être intercalées entre deux interfaces thermiques 33 ont une forme biseautée au niveau de leur surface inférieure, par exemple en double biseau sur toute sa longueur. On entend par « en double biseau » deux biseaux réalisés chacun d'un côté de la patte intérieure 23. Ce double biseau permet de n'endommager aucune des deux interfaces thermiques 33 entre lesquelles la patte intérieure 23 vient s'intercaler. Alternativement, la patte intérieure 23 a une forme arrondie au niveau de sa surface inférieure sur toute sa longueur, afin de n'endommager aucune interface thermique 33.

Les pattes extérieures 22 peuvent aussi avoir une forme biseautée au niveau de leur surface inférieure, par exemple en simple biseau dans le cas où elles ne sont en contact thermique qu'avec une barrette mémoire 30a et donc en contact direct avec une seule interface thermique 33 comme représenté à la Figure 3.

Dans une variante, une interface thermique 33 peut en outre être intercalée entre la surface de contact 24 de l'enveloppe 20a et le système de refroidissement 13.

Grâce à l'invention, le pas entre deux barrettes mémoire peut être par exemple de 8.3 millimètres. Par exemple, les interfaces thermiques 33 peuvent avoir une épaisseur de 1.5 millimètres, réduite à 1.3 millimètres lorsqu'elles sont compressées par l'insertion d'une patte intérieure 23. Une patte intérieure 23 peut par exemple avoir une épaisseur de 2.2 millimètres. Avec chaque barrette mémoire 30a ayant 3.5 millimètres d'épaisseur c'est-à-dire 1.75 millimètres du centre de la barrette mémoire à son bord, la distance centre à centre entre deux barrettes mémoires est bien de (1.75 * 2) + (1.3 * 2) + 2.2 = 8.3 millimètres.

Il apparaîtra à l'homme du métier que ces cotes peuvent être modifiées, une augmentation ou une réduction de l'épaisseur d'une patte intérieure 23 entraînant respectivement une augmentation ou une réduction de l'épaisseur de l'interface thermique 33 dans la limite du possible. De même, en utilisant des barrettes mémoire 30a plus épaisses, il est possible de garder la même épaisseur de patte intérieure 23 en réduisant l'épaisseur de l'interface thermique 33.

[Fig. 4] représente une vue selon un plan perpendiculaire au plan de la carte électronique 1 d'un dissipateur thermique selon un deuxième mode de réalisation l'invention.

Le plan de vue de la figure 4 est un plan selon les axes horizontal y et vertical z. Comme représenté à la figure 4, le dissipateur thermique 40 selon un deuxième mode de réalisation peut comprendre une enveloppe 20a, un système de fixation amovible 25 et un caloduc 26.

Le caloduc 26 est en contact thermique avec la surface de contact 24 et avec une patte extérieure 22 avec laquelle la surface de contact 24 n'est pas en contact thermique. Ainsi, le caloduc 26 permet de rediriger la chaleur captée par une patte extérieure 22 vers la surface de contact 24 et donc vers le système de refroidissement 13. Ce caloduc comprend par exemple une enveloppe en cuivre de forme tubulaire et à l'intérieur un matériau à changement de phase permettant l'évaporation et la condensation d'un fluide, afin de créer un flux de la source la plus chaude, où un fluide se vaporise, vers la source la plus froide, où le fluide se condense.

Un caloduc 26 peut par exemple être nécessaire lorsque le système de refroidissement fluidique 13 fonctionne avec un fluide ayant une température autour de 40 degrés Celsius. En effet, à une telle température de fonctionnement, les barrettes mémoire les plus éloignées du système de refroidissement fluidique 13 ne sont pas suffisamment refroidies par l'enveloppe 20a pour rester à une température inférieure à leur température maximale de fonctionnement, au-delà de laquelle elles arrêtent de fonctionner. Un caloduc est alors nécessaire pour rediriger la chaleur de la patte extérieure 22 la plus éloignée du système de refroidissement fluidique 13 ou la plus éloignée de la surface de contact 24, par exemple la patte extérieure 22 la plus à droite selon l'axe y sur la figure 4.

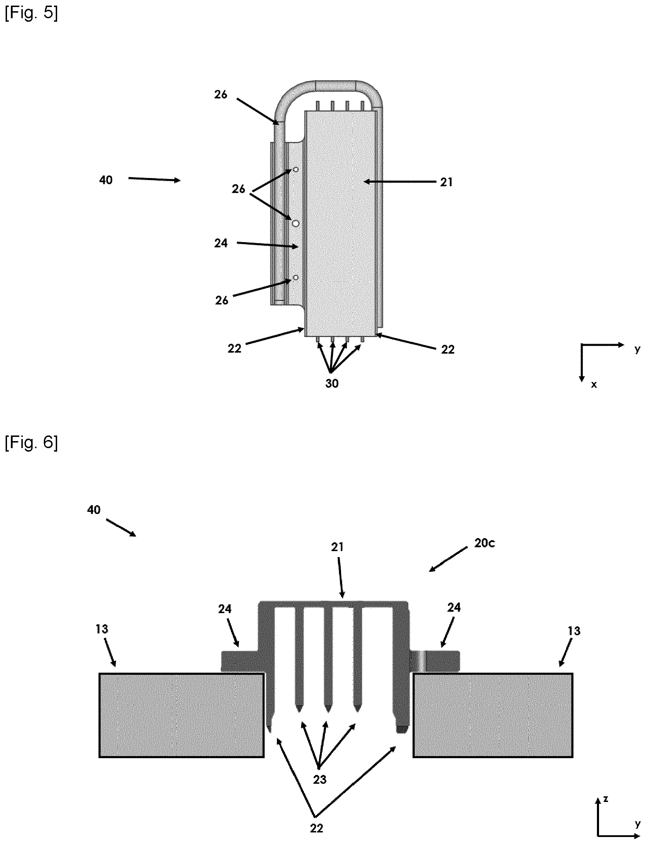

[Fig. 5] représente une vue de dessus dans le plan de la carte électronique 1 du dissipateur thermique 40 selon le deuxième mode de réalisation de l'invention.

Le caloduc 26 peut par exemple être en contact thermique avec la surface de contact 24 par contact direct avec la surface supérieure de la surface de contact 24. Le contact thermique peut aussi être réalisé en intercalant une interface thermique telle que l'interface thermique 33 entre la surface de contact 24 et le caloduc 26. La surface de contact 24 peut par exemple comprendre un usinage au niveau de sa surface supérieure de manière à accueillir le caloduc. Cet usinage peut par exemple être de la forme d'un demi-cylindre sur toute la longueur de la surface supérieure de la surface de contact 24, par exemple selon l'axe longitudinal x.

La caloduc 26 peut par exemple être en contact thermique avec la patte extérieure 22 la plus éloignée du système de refroidissement fluidique 13 et de la surface de contact 24. Ce contact thermique peut par exemple être un contact direct. II peut aussi être réalisé en intercalant une interface thermique telle que l'interface thermique 33 entre la patte extérieure 22 et le caloduc 26. La patte extérieure 22 en contact thermique avec le caloduc 26 peut par exemple comprendre un usinage au niveau de sa surface extérieure de manière à accueillir le caloduc. Cet usinage peut par exemple être de la forme d'un demi-cylindre sur toute la longueur de la surface extérieure de la surface extérieure 22, par exemple selon l'axe longitudinal x.

[Fig. 6] représente une vue selon un plan perpendiculaire au plan de la carte électronique 1 d'un dissipateur thermique 40 selon un troisième mode de réalisation de l'invention.

Dans ce troisième mode de réalisation de l'invention, une enveloppe 20c comprise dans le dissipateur thermique 40 est en contact thermique avec deux blocs du système de refroidissement fluidique 13. Cela permet avantageusement de se passer de caloduc 26, car la distance entre la barrette mémoire 30 la plus éloignée du système de refroidissement fluidique 13 et ledit système de refroidissement fluidique 13 est réduite de moitié. En effet, la barrette mémoire 30 la plus éloignée du système de refroidissement fluidique 13 est maintenant la ou les barrettes mémoire 30 au centre de la pluralité de barrettes mémoire 30.

Ce troisième mode de réalisation de l'invention implique une disposition particulière du système de refroidissement fluidique 13, par exemple qu'une pluralité de barrettes mémoire soit située entre deux processeurs refroidis par le système de refroidissement fluidique 13. Ainsi, les processeurs sont refroidis chacun avec un waterblock (selon la dénomination anglaise, traduit littéralement par « bloc d'eau ») compris dans le système de refroidissement fluidique 13, et les deux surfaces de contact 24 du dissipateur 40 sont en contact thermique avec les deux waterblock des deux processeurs refroidis par le système de refroidissement fluidique 13.

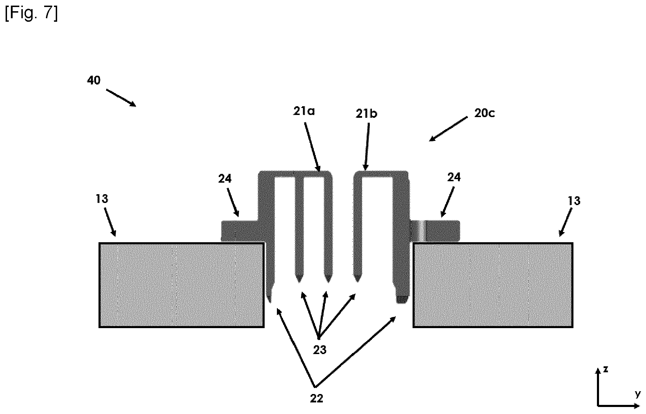

[Fig. 7] représente une vue selon un plan perpendiculaire au plan de la carte électronique 1 d'un dissipateur thermique 40 selon une variante au troisième mode de réalisation de l'invention.

Dans cette variante au troisième mode de réalisation de l'invention, l'enveloppe 20c comprise dans le dissipateur thermique 40 et dont les deux surfaces de contact 24 sont en contact chacune avec un bloc du système de refroidissement fluidique 13 comprend deux surfaces supérieures 21a et 21b.

Ainsi, comme représenté Figure 7, une partie de la pluralité de pattes intérieures 23 est en contact thermique avec la première surface supérieure 21a et une autre partie de la pluralité de pattes intérieures 23 est en contact thermique avec la seconde surface supérieure 21b. Dans un mode de réalisation préférentiel, les pattes intérieures 23 sont solidaires de la surface supérieure 21a ou 21b avec laquelle elles sont en contact thermique.

Un avantage de comprendre deux surfaces supérieures au lieu d'une est de diminuer la granularité, c'est-à-dire d'augmenter le nombre de pièces, permettant une maintenance plus simple. Un avantage supplémentaire est de diminuer l'effort d'insertion de l'enveloppe 20c entre et autour des barrettes mémoire 30a ou 30b.

## Revendications

1. Dissipateur thermique (12) pour une pluralité de barrettes mémoire (30, 30a, 30b) connectables à une carte électronique (1), , **caractérisé en ce qu'**il comprend au moins une enveloppe (20a, 20b, 20c), ladite enveloppe comprenant:
○ une surface supérieure (21, 21a, 21b) configurée pour recouvrir au moins partiellement la partie supérieure d'une barrette mémoire (30, 30a, 30b)d'une pluralité de barrettes mémoire,
○ au moins deux pattes extérieures (22), chaque patte extérieure (22) étant configurée pour être en contact thermique avec au moins une surface d'échange thermique parmi les deux surfaces d'échange thermique d'au moins une barrette mémoire (30, 30a, 30b) de la pluralité de barrettes mémoire,
○ au moins une surface de contact (24), configurée pour être en contact thermique avec un système de refroidissement fluidique (10) de ladite carte électronique (1) lorsque chaque barrette mémoire (30, 30a, 30b) de la pluralité de barrettes mémoire est connectée à ladite carte électronique (1),
○ au moins une patte intérieure (23), configurée pour être intercalée entre deux barrettes mémoire (30, 30a, 30b) de la pluralité de barrettes mémoire afin de réaliser un contact thermique avec au moins une surface d'échange thermique parmi les deux surfaces d'échange thermique de chacune des deux barrettes mémoire (30, 30a, 30b),
- ladite enveloppe (20a, 20b, 20c) est configurée pour être placée de manière amovible contre les deux surfaces d'échange de chaque barrette mémoire (30, 30a, 30b) de la pluralité de barrettes mémoire,
- ladite enveloppe (20a, 20b, 20c) est configurée pour être fixée mécaniquement de manière amovible à ladite carte électronique (1) lorsque chaque barrette mémoire de la pluralité de barrettes mémoire (30, 30a, 30b) est connectée à ladite carte électronique (1), **caractérisé en ce que** la au moins une patte extérieure présente une forme biseautée ou arrondie au niveau de sa surface inférieure.

2. Dissipateur thermique (12) selon la revendication 1 **caractérisé en ce qu'**il comprend en outre une pluralité d'interfaces thermiques, chaque interface thermique (33) étant intercalée soit entre une surface d'échange d'une barrette mémoire (30, 30a, 30b) de la pluralité de barrettes mémoire et une patte extérieure (22) de l'enveloppe (20a, 20b, 20c), soit entre une surface d'échange d'une barrette mémoire (30, 30a, 30b) de la pluralité de barrettes mémoire et une patte intérieure (23) de l'enveloppe (20a, 20b, 20c).

3. Dissipateur thermique (12) selon l'une quelconque des revendications précédentes **caractérisé en ce que** la au moins une surface supérieure (21, 21a, 21b), les au moins deux pattes extérieures (22) et la au moins une patte intérieure (23) sont agencées de façon à former, pour chaque barrette mémoire (30, 30a, 30b) de la pluralité de barrettes mémoire, un espace adapté à recevoir la barrette mémoire (30, 30a, 30b).

4. Dissipateur thermique (12) selon l'une quelconque des revendications précédentes **caractérisé en ce qu'**il comprend deux surfaces de contact (24), chaque surface de contact (24) étant en contact thermique avec le système de refroidissement fluidique (10).

5. Dissipateur thermique (12) selon l'une quelconque des revendications précédentes **caractérisé en ce qu'**il comprend deux surfaces supérieures (21a, 21b).

6. Dissipateur thermique (12) selon l'une quelconque des revendications précédentes **caractérisé en ce qu'**il comprend en outre un caloduc (26) configuré pour être en contact thermique avec la surface de contact (24) et avec la patte extérieure (22) de l'enveloppe (20a, 20b, 20c) du dissipateur thermique (12) la plus éloignée de la surface de contact (24).

7. Carte électronique (1) comprenant au moins un système de refroidissement fluidique (10), une pluralité de barrettes mémoire (30, 30a, 30b), au moins un premier connecteur électrique pour chaque barrette mémoire, chaque barrette mémoire (30, 30a, 30b)comprenant au moins un deuxième connecteur (31) configuré pour être connecté à au moins un premier connecteur de la carte électronique (1) et le dissipateur thermique (12) selon l'une quelconque des revendications précédentes.

## Patentansprüche

1. Kühlkörper (12) für eine Vielzahl von Speichermodulen (30, 30a, 30b), die mit einer Elektronikkarte (1) verbindbar sind, **dadurch gekennzeichnet, dass** er mindestens eine Ummantelung (20a, 20b, 20c) umfasst, die Ummantelung umfassend:
∘ eine obere Oberfläche (21, 21a, 21b), die zum Bedecken mindestens teilweise des oberen Teils eines Speichermoduls (30, 30a, 30b) einer Vielzahl von Speichermodulen konfiguriert ist,
∘ mindestens zwei äußere Lappen (22), wobei jeder äußere Lappen (22) konfiguriert ist, um mit mindestens einer Wärmeaustauschoberfläche unter den zwei Wärmeaustauschoberflächen mindestens eines Speichermoduls (30, 30a, 30b) der Vielzahl von Speichermodulen in Wärmekontakt zu stehen,
∘ mindestens eine Kontaktoberfläche (24), die konfiguriert ist, um mit einem Fluidabkühlsystem (10) der Elektronikkarte (1) in Wärmekontakt zu stehen, wenn jedes Speichermodul (30, 30a, 30b) der Vielzahl von Speichermodulen mit der Elektronikkarte (1) verbunden ist,
∘ mindestens einen inneren Lappen (23), der konfiguriert ist, um zwischen zwei Speichermodulen (30, 30a, 30b) der Vielzahl von Speichermodulen eingefügt zu sein, um einen Wärmekontakt mit mindestens einer Wärmeaustauschoberfläche unter den zwei Wärmeaustauschoberflächen von jedem der zwei Speichermodule (30, 30a, 30b) herzustellen,
- wobei die Ummantelung (20a, 20b, 20c) konfiguriert ist, um auf abnehmbare Weise gegen die zwei Wärmeaustauschoberflächen jedes Speichermoduls (30, 30a, 30b) der Vielzahl von Speichermodulen platziert zu werden,
- wobei die Ummantelung (20a, 20b, 20c) konfiguriert ist, um auf abnehmbare Weise an der Elektronikkarte (1) befestigt zu werden, wenn jedes Speichermodul der Vielzahl von Speichermodulen (30, 30a, 30b) mit der Elektronikkarte (1) verbunden ist, **dadurch gekennzeichnet, dass** der mindestens eine äußere Lappen eine abgeschrägte oder eine abgerundete Form an seiner inneren Oberfläche vorweist.

2. Kühlkörper (12) nach Anspruch 1, **dadurch gekennzeichnet, dass** er ferner eine Vielzahl von Wärmeschnittstellen umfasst, wobei jede Wärmeschnittstelle (33) zwischen einer Austauschoberfläche eines Speichermoduls (30, 30a, 30b) der Vielzahl von Speichermodulen und einem äußeren Lappen (22) der Ummantelung (20a, 20b, 20c) eingefügt ist, nämlich zwischen einer Austauschoberfläche eines Speichermoduls (30, 30a, 30b) der Vielzahl von Speichermodulen und einem inneren Lappen (23) der Ummantelung (20a, 20b, 20c).

3. Kühlkörper (12) nach einem der vorstehenden Ansprüche,
**dadurch gekennzeichnet, dass** die mindestens eine obere Oberfläche (21, 21a, 21b), die mindestens zwei äußeren Lappen (22) und der mindestens eine innere Lappen (23) angeordnet sind, um für jedes Speichermodul (30, 30a, 30b) der Vielzahl von Speichermodulen einen Raum auszubilden, der geeignet ist, um das Speichermodul (30, 30a, 30b) aufzunehmen.

4. Kühlkörper (12) nach einem der vorstehenden Ansprüche,
**dadurch gekennzeichnet, dass** er zwei Kontaktoberflächen (24) umfasst, wobei jede Kontaktoberfläche (24) mit dem Fluidabkühlsystem (10) in Wärmekontakt steht.

5. Kühlkörper (12) nach einem der vorstehenden Ansprüche,
**dadurch gekennzeichnet, dass** er zwei obere Oberflächen (21a, 21b) umfasst.

6. Kühlkörper (12) nach einem der vorstehenden Ansprüche,
**dadurch gekennzeichnet, dass** er ferner ein Wärmerohr (26) umfasst, das konfiguriert ist, um mit der Kontaktoberfläche (24) und mit dem äußeren Lappen (22) der Ummantelung (20a, 20b, 20c) des Kühlkörpers (12) in Wärmekontakt zu stehen, der von der Kontaktoberfläche (24) am weitesten entfernt ist.

7. Elektronikkarte (1), umfassend mindestens ein Fluidabkühlsystem (10), eine Vielzahl von Speichermodulen (30, 30a, 30b), mindestens einen ersten elektrischen Verbinder für jedes Speichermodul, jedes Speichermodul (30, 30a, 30b) umfassend mindestens einen zweiten Verbinder (31), der konfiguriert ist, um mit mindestens einem Verbinder der Elektronikkarte (1) verbunden zu werden, und den Kühlkörper (12) nach einem der vorstehenden Ansprüche.

## Claims

1. Heat sink (12) for a plurality of memory modules (30, 30a, 30b) that are connectable to an electronic board (1), **characterized in that** it comprises at least one envelope (20a, 20b, 20c), said envelope comprising:
∘ an upper surface (21, 21a, 21b) designed to at least partially cover the upper portion of a memory module (30, 30a, 30b) of a plurality of memory modules,
∘ at least two outer tabs (22), each outer tab (22) being designed to be in thermal contact with at least one heat exchange surface among the two heat exchange surfaces of at least one memory module (30, 30a, 30b) of the plurality of memory modules,
∘ at least one contact surface (24), designed to be in thermal contact with a fluidic cooling system (10) of said electronic board (1) when each memory module (30, 30a, 30b) of the plurality of memory modules is connected to said electronic board (1),
∘ at least one inner tab (23), designed to be interposed between two memory modules (30, 30a, 30b) of the plurality of memory modules in order to establish thermal contact with at least one heat exchange surface among the two heat exchange surfaces of each of the memory modules (30, 30a, 30b),
- said envelope (20a, 20b, 20c) being designed to be removably placed against the two exchange surfaces of each memory module (30, 30a, 30b) of the plurality of memory modules,
- said envelope (20a, 20b, 20c) being designed to be removably mechanically secured to said electronic board (1) when each memory module of the plurality of memory modules (30, 30a, 30b) is connected to said electronic board (1),
**characterized in that** the at least one outer tab has a beveled or rounded shape on its inner surface.

2. Heat sink (12) according to claim 1 **characterized in that** it further comprises a plurality of thermal interfaces, each thermal interface (33) being interposed either between an exchange surface of a memory module (30, 30a, 30b) of the plurality of memory modules and an outer tab (22) of the envelope (20a, 20b, 20c), or between an exchange surface of a memory module (30, 30a, 30b) of the plurality of memory modules and an inner tab (23) of the envelope (20a, 20b, 20c).

3. Heat sink (12) according to either of the preceding claims, **characterized in that** the at least one upper surface (21, 21a, 21b), the at least two outer tabs (22) and the at least one inner tab (23) are arranged so as to form, for each memory module (30, 30a, 30b) of the plurality of memory modules, a space suitable for receiving the memory module (30, 30a, 30b).

4. Heat sink (12) according to any of the preceding claims,
**characterized in that** it comprises two contact surfaces (24), each contact surface (24) being in thermal contact with the fluidic cooling system (10).

5. Heat sink (12) according to any of the preceding claims,
**characterized in that** it comprises two upper surfaces (21a, 21b).

6. Heat sink (12) according to any of the preceding claims,
**characterized in that** it further comprises a heat pipe (26) designed to be in thermal contact with the contact surface (24) and with the outer tab (22) of the envelope (20a, 20b, 20c) of the heat sink (12) that is furthest from the contact surface (24).

7. Electronic board (1) comprising at least one fluidic cooling system (10), a plurality of memory modules (30, 30a, 30b), and at least a first electrical connector for each memory module, each memory module (30, 30a, 30b) comprising at least a second connector (31), designed to be connected to at least a first connector of the electronic board (1), and the heat sink (12) according to any of the preceding claims.
